(19) Europäisches Patentamt
European Patent Office
Office européen des brevets

(11) Numéro de publication : **0 016 909**
**B1**

(12) **FASCICULE DE BREVET EUROPÉEN**

(45) Date de publication du fascicule du brevet : **01.09.82**

(51) Int. Cl.³ : **H 01 L 21/316**, H 01 J 37/32// C23F7/02

(21) Numéro de dépôt : **80100325.2**

(22) Date de dépôt : **23.01.80**

(54) **Procédé de croissance d'oxyde par plasma sur des substrats semi-conducteurs et dispositif pour la mise en oeuvre de ce procédé.**

(30) Priorité : **01.03.79 US 16648**

(43) Date de publication de la demande : **15.10.80 (Bulletin 80/21)**

(45) Mention de la délivrance du brevet : **01.09.82 Bulletin 82/35**

(84) Etats contractants désignés : **DE FR GB**

(56) Documents cités :
**DE - B2 - 2 351 395**
**FR - A - 1 403 466**
**SOLID STATE ELECTRONICS, Vol. 17, 1974 Oxford, D.L. PULFREY et al. « Preparation and properties of plasma-anodized silicon dioxide films ».**

(73) Titulaire : **International Business Machines Corporation**
**Armonk, N.Y. 10504 (US)**

(72) Inventeur : **Ray, Asit Kumar**
**70 Barker Street**
**Mt. Kisco, New York 10549 (US)**
Inventeur : **Reisman, Arnold**
**2294 Van Cortland Circle**
**Yorktown Heights New York 10598 (US)**

(74) Mandataire : **Colas, Alain**
**COMPAGNIE IBM FRANCE Département de Propriété Industrielle**
**F-06610 La Gaude (FR)**

**EP 0 016 909 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Imprimerie Jouve, 18, rue St-Denis, 75001 Paris, France

# Procédé de croissance d'oxyde par plasma sur des substrats semi-conducteurs et dispositif pour la mise en œuvre de ce procédé.

## Description

### Domaine technique

La présente invention concerne la formation des oxydes sur des substrats semi-conducteurs au cours de la fabrication de circuits intégrés.

### Etat de la technique antérieure

Selon l'art antérieur, l'oxydation des substrats semi-conducteurs est exécutée thermiquement dans une atmosphère humide ou sèche et dans ces conditions, le taux de croissance de l'oxyde n'est pas uniforme car la croissance comporte une première partie linéaire relativement courte suivie d'une seconde partie de nature parabolique.

En raison de l'ultra-miniaturisation des dispositifs, les procédés classiques d'oxydation thermique deviennent de plus en plus difficiles à exécuter en raison du fait qu'aux températures élevées impliquées dans les structures complexes de développement, les profils d'impuretés des dispositifs semi-conducteurs sont redistribués, ce qui affecte d'une manière significative la conception des dispositifs.

On a recherché une technique d'oxydation pouvant être pratiquée à des températures plus faibles, de préférence inférieures à 700 °C, impliquant de très faibles coefficients de diffusion d'impuretés.

La formation d'oxyde par plasma sur des semi-conducteurs est appelée « croissance par plasma », « oxydation par plasma » ou encore, dans les cas où le substrat semi-conducteur fait partie de l'électrode d'anode, « anodisation par plasma ». La formation d'oxyde à courant et pression constants, sans contrôle de la température, est décrite dans la revue « Solid States Electronics », Vol. 17, page 627, 1974.

On aurait cependant besoin d'une technique simplifiée de croissance par plasma à faible température permettant d'obtenir un oxyde reproductible uniforme à caractéristiques électriques et physiques similaires à celles obtenues par l'application de procédés thermiques à haute température.

### Exposé de l'invention

La présente invention concerne un procédé de formation d'oxyde par plasma dans lequel on dispose le substrat semi-conducteur en dehors de la région du plasma, on applique une chaleur indépendante et contrôlable au substrat et on commande indépendamment la pression d'oxygène du conteneur ou du dispositif de croissance.

Le taux de croissance de l'oxyde augmente à mesure que l'on augmente l'alimentation du générateur de plasma et diminue lorsque l'on augmente la pression. La reproductibilité de l'épaisseur de l'oxyde est de l'ordre de 2 à 4 %.

D'autres caractéristiques et avantages de la présente invention ressortiront mieux de l'exposé qui suit, fait en référence aux dessins annexés à ce texte, qui représentent un mode de réalisation préféré de celle-ci.

### Brève description des figures

La Figure 1 représente un dispositif tel qu'utilisé dans le procédé de la présente invention et illustrant les paramètres à commander.

La Figure 2 représente graphiquement la variation du taux de croissance de l'oxyde en fonction de la puissance d'alimentation.

La Figure 3 représente graphiquement la variation du taux de croissance de l'oxyde en fonction de la pression.

La Figure 4 représente graphiquement la variation de l'épaisseur de l'oxyde en fonction du temps.

### Description de l'invention

La Figure 1 représente un dispositif approprié pour la mise en œuvre de la présente invention. Le conteneur 1 peut être vidé puis rempli d'une quantité donnée d'oxygène 2 à une pression déterminée. Le conteneur 1 contient un dispositif qui assure la génération du plasma, ce dispositif consistant en une bobine d'induction 3 connectée, par des connecteurs appropriés 4 et 5, à un générateur de haute fréquence à puissance variable 6. Ce dispositif engendre une région de plasma 7 dans laquelle l'atmosphère contrôlée 2 est ionisée par excitation à haute fréquence.

Les substrats semi-conducteurs 8 sont disposés sur un porte-substrats 9 qui est équipé d'une source de chaleur indépendante 10. L'atmosphère ambiante 2 est maintenue à une pression précise indiquée par le manomètre 11. L'oxygène est introduit dans le conteneur, à partir d'une source de pression d'oxygène $O_2$, par l'intermédiaire d'une valve 12 qui commande le débit d'oxygène et de l'entrée 13. Cet oxygène est évacué par le conduit 14 commandé par la valve 15.

Selon la présente invention, la croissance d'oxyde à faible température est assurée par la commande indépendante de la température et de la pression. Ces commandes indépendantes sont assurées par l'intermédiaire du dispositif de commande de température de substrat 10 installé séparément et en dehors de la région de plasma 7 et par l'intermédiaire de l'alimentation variable du générateur de plasma obtenue par la source à haute fréquence 6.

Aucune pulvérisation ou contamination d'électrode n'apparaît dans la structure de la présente invention.

Les substrats 8 sont placés de telle façon qu'en tenant compte de la faible différence de pression qui existe dans le conteneur, l'oxygène excité peut passer de la région de plasma 7 à la région des substrats. Les substrats 8 sont de préférence disposés à 20 cm du centre de la bobine d'induction 3. De plus, les substrats 8 sont chauffés de façon indépendante et ce chauffage est commandé par l'intermédiaire de la source de chaleur à résistance 10. Dans ces conditions, l'oxygène actif qui entraîne la croissance de l'oxyde passe de la région de plasma 7 au substrat 8.

Dans le cas de substrats en silicium, on maintient de préférence l'atmosphère ambiante 2 dans une plage de pression inférieure à 3 mtorr en utilisant les valves de commandes 12 et 15.

Dans un exemple préféré où le substrat est en silicium le matériau utilisé dans le système de la Figure 1 est le quartz et la purification de l'oxygène introduit par l'ouverture 13 est assuré en utilisant un tube de décomposition à quartz à 1 000 °C classique suivi par un piège à azote liquide.

Les substrats 8 sont maintenus par l'élément chauffant 10 à une température comprise entre 300 et 800 °C et peuvent soit être sans oxyde, soit déjà comporter une certaine quantité d'oxyde, par exemple de 120 à $300 \times 10^{-3}$ microns d'oxyde thermique.

Le dispositif de la présente invention permettant la commande indépendante de la pression, de l'alimentation et de la température, on peut faire varier le taux de croissance de quelques $10^{-3}$ microns à quelques centaines de $10^{-3}$ microns par heure. Ce résultat est atteint avec des températures comprises entre 300° et 800 °C.

Le taux de croissance d'oxyde, en utilisant le dispositif de la présente invention dans cette plage de température et de pression en fonction de l'alimentation, est représenté graphiquement à la Figure 2. Par exemple, et en remarquant que la Figure 2 est une représentation à échelle logarithmique, le taux de croissance à 650 °C et à 2,5 mtorr, varie linéairement avec l'alimentation lorsque la valeur de cette dernière est comprise entre 1 et 6 kilowatts et varie exponentiellement à la puissance 4,5 de l'alimentation lorsque la valeur de celle-ci dépasse 6 kilowatts.

La Figure 3 montre la dépendance du taux de croissance par rapport à la pression dans le cas où la température est de 650 °C et la puissance de 7 kilowatts, étant entendu que l'on rencontre la même dépendance à toutes les températures comprises entre 300 et 800 °C.

La Figure 4 montre la variation de l'épaisseur d'oxyde en fonction du temps à une température de 650 °C, à une pression de 2,5 mtorr et à une puissance de 4,5 kilowatts.

La croissance de l'oxyde dans le procédé de la présente invention s'effectue continuement et toujours linéairement en fonction du temps ce qui indique un procédé à réaction limitée en surface. La croissance de l'oxyde sur la surface d'une pastille d'environ 5,7 cm de diamètre ne présente que des variations d'épaisseur de 2 à 4 % avec un indice de réfraction et une résistance à la rupture comparables à ceux d'une pastille sur laquelle est réalisée une croissance d'oxyde thermique et sèche entre 1 000 et 1 100 °C.

On a décrit un procédé de formation d'oxyde uniforme par plasma à faible température pour lequel on place le substrat en dehors de la région de plasma dans un dispositif où le générateur de plasma, l'alimentation en oxygène, la pression et la température du substrat sont commandés de façon indépendante.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de croissance d'oxyde par plasma sur des substrats semi-conducteurs, du genre dans lequel les substrats (8) sont placés dans une enceinte (1) comportant une région à plasma (7), caractérisé en ce que l'on dispose lesdits substrats en dehors de la zone de plasma et ce, à une distance définie de la zone de génération de plasma, cette distance étant déterminée par la distribution des pressions dans l'enceinte, et en ce que l'on commande, de façon indépendante, la température des substrats, la pression de l'oxygène contenu dans l'enceinte (1) et l'alimentation du générateur de plasma (6).

2. Dispositif de croissance d'oxyde par plasma sur des substrats semi-conducteurs, du genre dans lequel : les substrats (8) sont supportés par un porte-substrats (9), l'ensemble substrats/porte-substrats étant placé dans une enceinte (1) comportant une région à plasma (7), une source d'oxygène commandée permet de faire varier la pression et le débit d'oxygène dans ladite enceinte (1) comportant l'ensemble substrat/porte-substrats et la région à plasma (7), le dispositif étant caractérisé en ce qu'il comporte en outre : une source de plasma (3, 6) à alimentation variable et pouvant être contrôlée, une source de chaleur indépendante (10) pour chauffer les substrats semi-conducteurs (8), ceux-ci étant situés à une distance déterminée de la zone de génération dudit plasma.

3. Dispositif selon la revendication 2, caractérisé en ce que la puissance du générateur de plasma est comprise entre 1 et 6 kilowatts.

4. Dispositif selon la revendication 2, caractérisé en ce que la puissance du générateur de plasma est supérieure à 6 kilowatts.

5. Dispositif selon l'une quelconque des revendications 2 à 4, caractérisé en ce que ladite pression d'oxygène est inférieure à 3 mtorr.

6. Dispositif selon l'une quelconque des revendications 2 à 5, caractérisé en ce que la température des substrats est comprise entre 300 et 800 °C.

7. Dispositif selon l'une quelconque des revendications 2 à 6, caractérisé en ce que le plasma est produit par un dispositif à plasma sans électrode.

8. Dispositif selon l'une quelconque des revendications 2 à 7, caractérisé en ce que le substrat semi-conducteur est en silicium.

9. Dispositif selon l'une quelconque des revendications 2 à 8, caractérisé en ce que le substrat semi-conducteur est situé à environ 20 cm de la zone de génération de plasma.

**Claims**

1. A method for producing plasma oxide growth on semiconductor substrates of the type where the substrates (8) are placed in a container (1) including a plasma region (7), characterized in that said substrates are placed outside the plasma region at a given distance from the plasma generation region, this distance being determined by the pressure distribution in the container, and that the substrate temperature, the pressure of the oxygen contained in said container (1), and the power supply of the plasma generator (6) are controlled independently.

2. A device for producing plasma oxide growth on semiconductor substrates of the type where : the substrates (8) are supported by a substrate carrier (9), the substrates/substrate carrier arrangement being placed in the container (1) including a plasma region (7), a controlled oxygen source allows the pressure and the oxygen flow to be varied in said container (1) including the substrates/substrate carrier arrangement and the plasma region (7), characterized in that it furthermore includes : a controllable plasma source (3, 6) with variable supply, an independent heat source (10) for heating the semiconductor substrates (8), said substrates being placed at a given distance from the generation region of said plasma.

3. A device according to claim 2, characterized in that the power of the plasma generator ranges from 1 to 6 kilowatts.

4. A device according to claim 2, characterized in that the power of the plasma generator exceeds 6 kilowatts.

5. A device according to any one of claims 2 to 4, characterized in that said oxygen pressure is less than 3 mtorr.

6. A device according to any one of claims 2 to 5, characterized in that the temperature of the substrates ranges from 300 to 800 °C.

7. A device according to any one of claims 2 to 6, characterized in that the plasma is produced by an electroless plasma device.

8. A device according to any one of claims 2 to 7, characterized in that the semiconductor substrate consists of silicon.

9. A device according to any one of claims 2 to 8, characterized in that the semiconductor substrate is located about 20 cm from the plasma generation region.

**Ansprüche**

1. Verfahren zum Aufwachsen von Oxid mittels eines Plasmas auf Halbleitersubstraten, bei dem die Substrate (8) in einer einen Plasmabereich (7) enthaltenden Kammer (1) angeordnet sind, dadurch gekennzeichnet, daß sich die Substrate außerhalb des Plasmabereiches in einem bestimmten Abstand von dem Plasmaerzeugungsbereich befinden, wobei dieser Abstand durch die Verteilung der Drucke in der Kammer bestimmt wird, und daß die Temperatur der Substrate, der in der Kammer (1) befindliche Sauerstoffdruck und die Energieversorgung des Plasmagenerators (6) unabhängig voneinander gesteuert werden.

2. Vorrichtung zum Aufwachsen von Oxid mittels eines Plasmas auf Halbleitersubstraten, bei welcher : die Substrate (8) von einem Substrathalter (9) unterstützt werden, wobei die Anordnung aus den Substraten und dem Substratträger in einer einen Plasmabereich (7) enthaltenden Kammer (1) angeordnet wird, eine gesteuerte Sauerstoffquelle die Möglichkeit bietet, den Druck in und die Sauerstoffzuführung zu der Kammer (1) zu variieren, die die Anordnung aus den Substraten und dem Substratträger und den Plasmabereich (7) einschließt, dadurch gekennzeichnet, daß sie ferner einschließt : eine steuerbare Plasmaquelle (3, 6) mit variabler Energieversorgung, eine unabhängige Wärmequelle (10) zum Erhitzen der Halbleitersubstrate (8), wobei sich diese in einem bestimmten Abstand von dem Bildungsbereich des Plasmas befinden.

3. Vorrichtung nach Anspruch 2, dadurch gekennzeichnet, daß die Leistung des Plasmagenerators zwischen 1 und 6 Kilowatt liegt.

4. Vorrichtung nach Anspruch 2, dadurch gekennzeichnet, daß die Leistung des Plasmagenerators 6 Kilowatt übersteigt.

5. Vorrichtung nach einem der Ansprüche 2 bis 4, dadurch gekennzeichnet, daß der Sauerstoffdruck unter 4 µbar liegt.

6. Vorrichtung nach einem der Ansprüche 2 bis 5, dadurch gekennzeichnet, daß die Temperatur der Substrate zwischen 300 und 800 °C liegt.

7. Vorrichtung nach einem der Ansprüche 1 bis 6, dadurch gekennzeichnet, daß das Plasma von einer Plasmavorrichtung ohne Elektrode erzeugt wird.

8. Vorrichtung nach einem der Ansprüche 2 bis 7, dadurch gekennzeichnet, daß das Halbleitersubstrat aus Silizium besteht.

9. Vorrichtung nach einem der Ansprüche 2 bis 8, dadurch gekennzeichnet, daß sich das Halbleitersubstrat ungefähr 20 cm von dem Erzeugungsbereich des Plasmas befindet.

FIG. 1

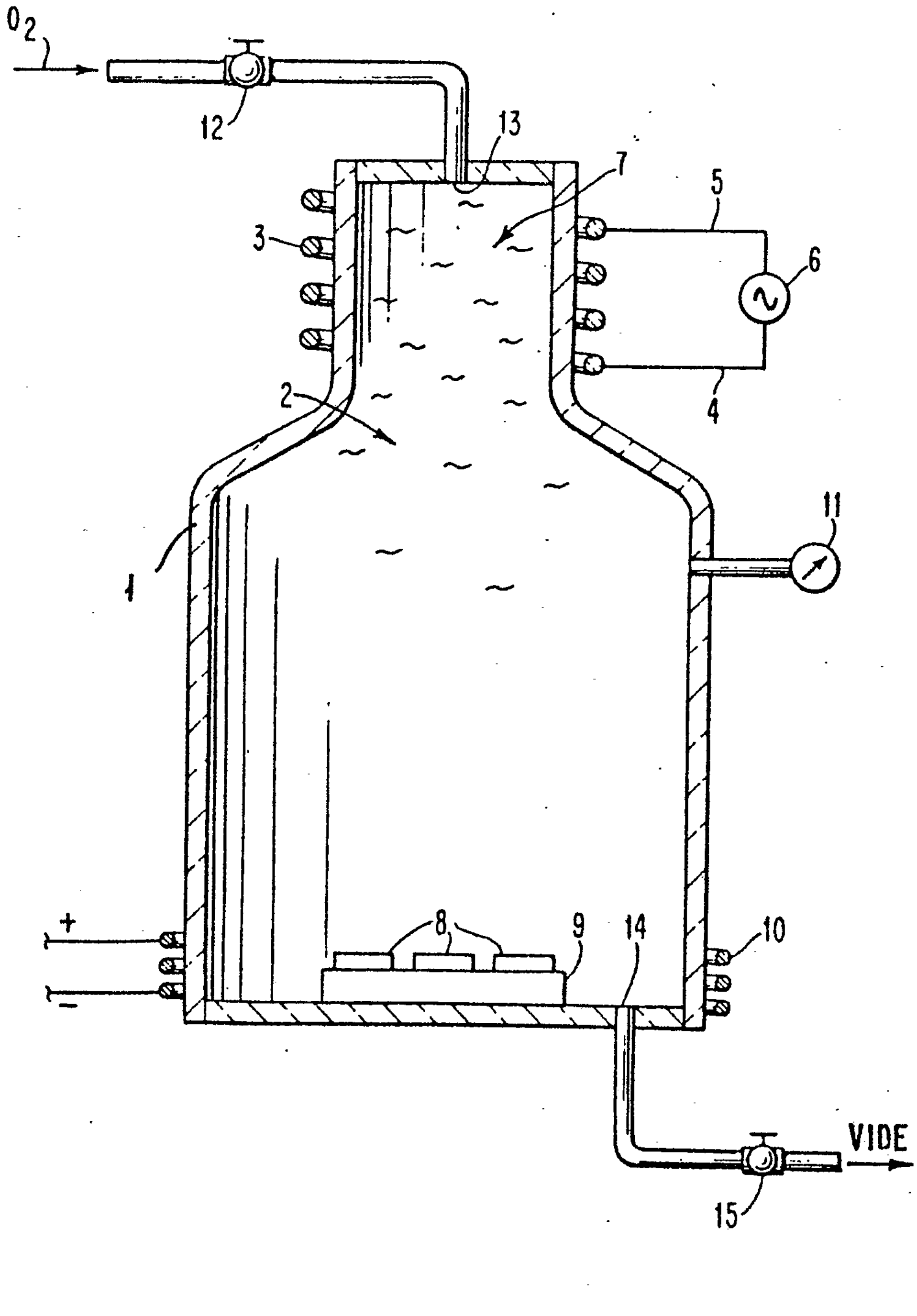

FIG. 2

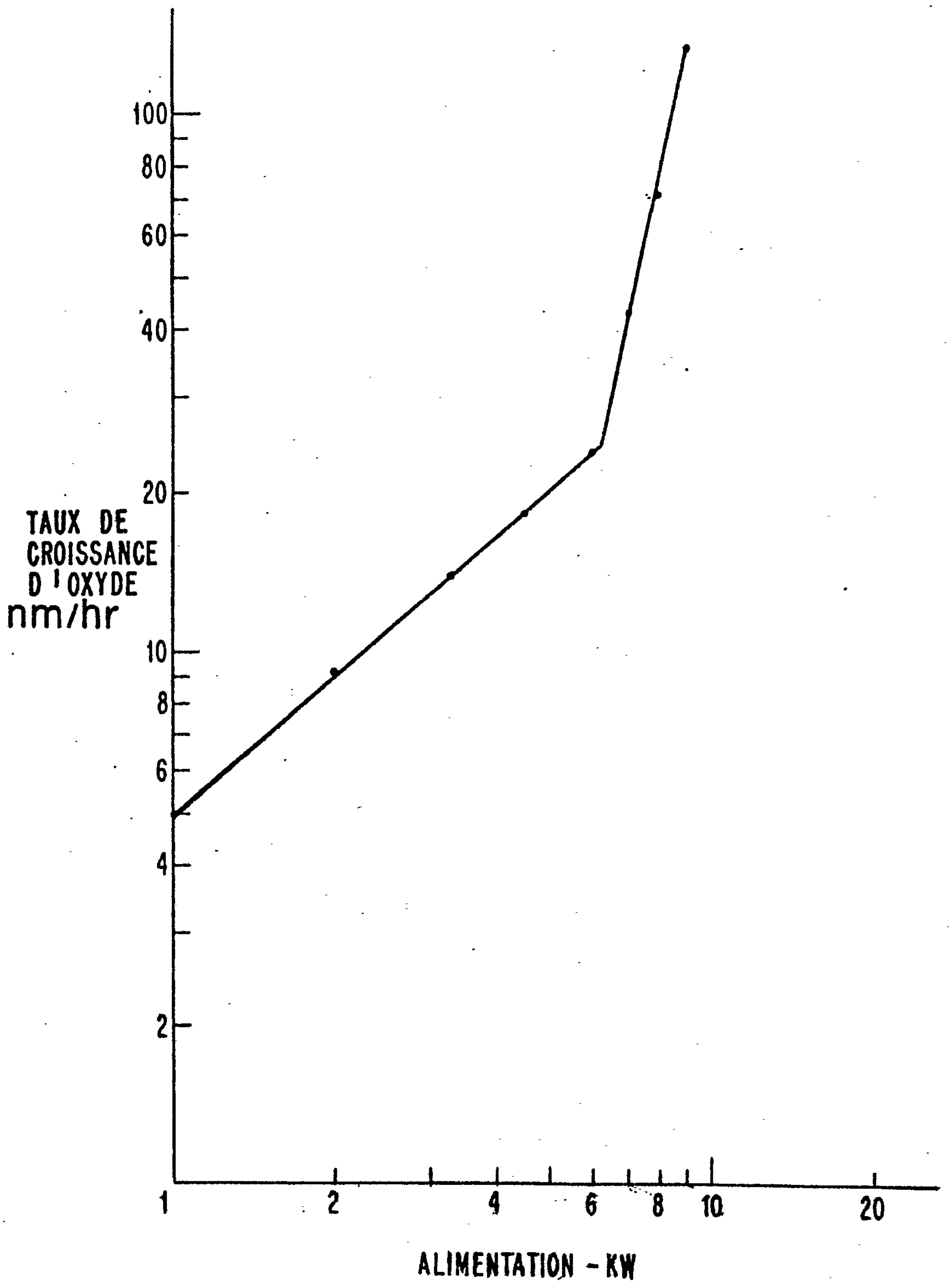
100
80
60
40
20
10
8
6
4
2
TAUX DE
CROISSANCE
D'OXYDE
nm/hr
1
2
4
6
8
10
20
ALIMENTATION - KW

FIG. 3

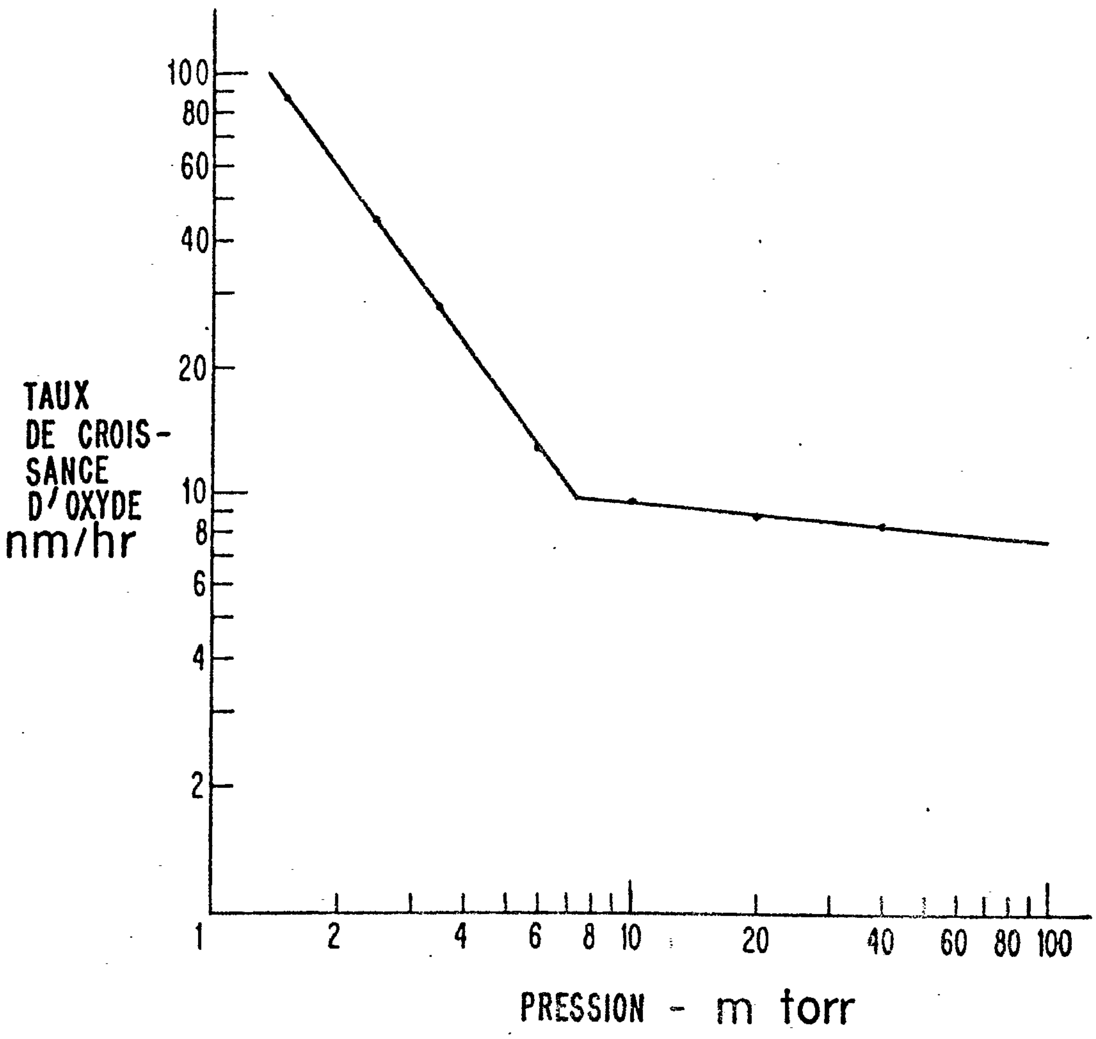
100
80
60
40
20
10
8
6
4
2
TAUX DE CROISSANCE D'OXYDE nm/hr
1
2
4
6
8
10
20
40
60
80
100
PRESSION - m torr

FIG. 4

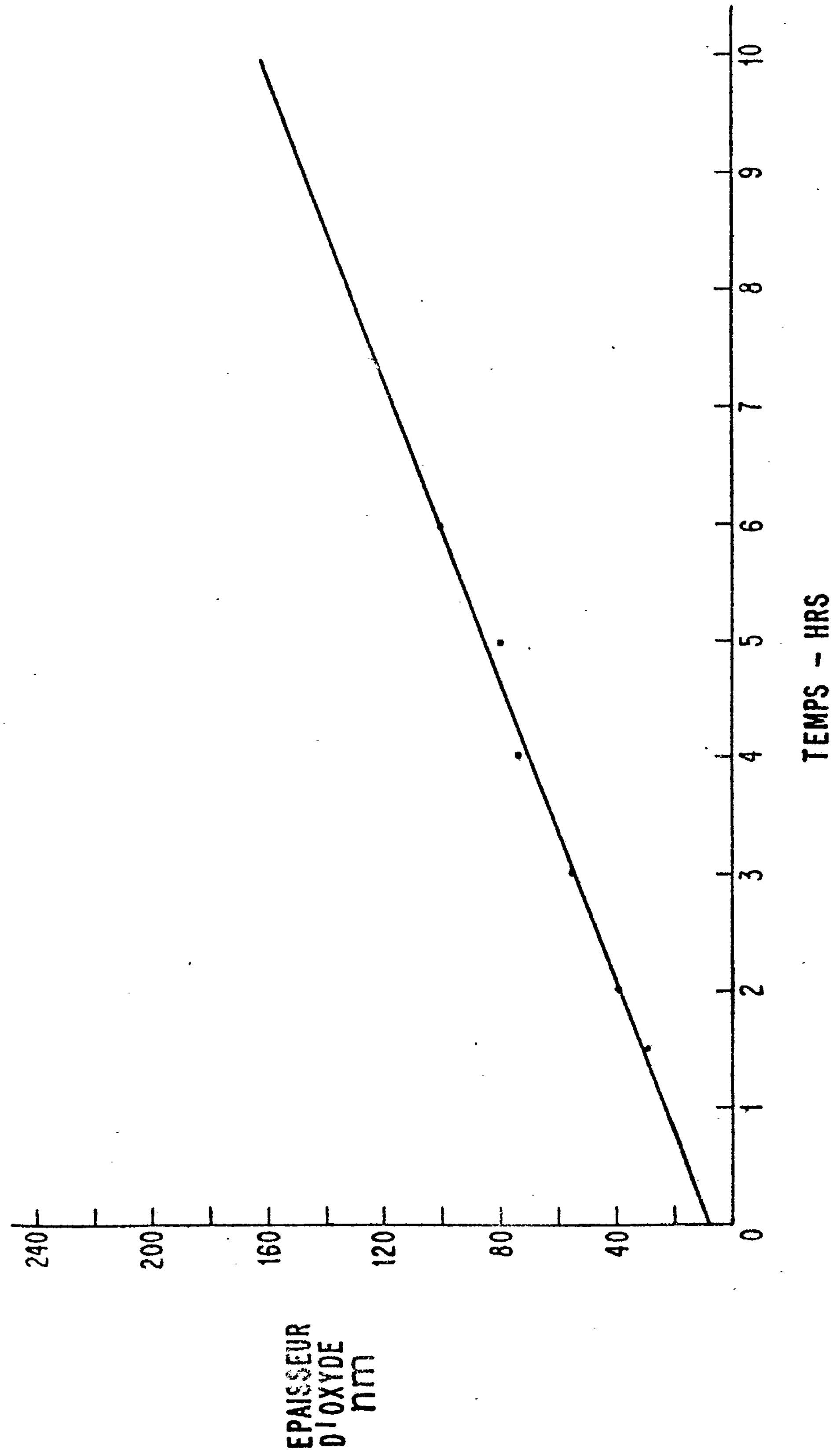

EPAISSEUR D'OXYDE nm
240
200
160
120
80
40
0
1
2
3
4
5
6
7
8
9
10
TEMPS - HRS